# EUROPEAN PATENT SPECIFICATION

(11) **EP 3 113 591 B1**
(45) Date of publication and mention of the grant of the patent: **18.04.2018**
(21) Application number: 16176006.1
(22) Date of filing: 23.06.2016
(51) Int. Cl.: H05K 7/20, F24F 5/00, F24F 11/00, F28F 25/04, F28C 1/14, F28D 15/00, G01R 21/00, F28F 25/06

(54) **CONDITIONING UNIT OF THE FREE COOLING TYPE AND METHOD OF OPERATION OF SUCH A CONDITIONING UNIT**
KLIMAANLAGE MIT FREIER KÜHLUNG SOWIE VERFAHREN ZUM BETRIEB SOLCH EINER KLIMAANLAGE
UNITÉ DE CONDITIONNEMENT DU TYPE À REFROIDISSEMENT LIBRE ET PROCÉDÉ DE FONCTIONNEMENT D'UNE TELLE UNITÉ

(30) Priority: 29.06.2015 IT UB20151743
(43) Date of publication of application: 04.01.2017
(73) Proprietor: Vertiv S.R.L., 35028 Piove di Sacco (PD) (IT)
(72) Inventor: BARBATO, Pierpaolo, 35027 NOVENTA PADOVANA (IT)
(74) Representative: Modiano, Micaela Nadia

(56) References cited:
- JP-A- 2009 217 500
- US-A1- 2008 288 193
- US-A1- 2011 256 822
- US-B1- 8 151 578
- US-B1- 8 223 495

## Description

The present invention relates to a conditioning unit of the free cooling type, and to a method of operation of such a conditioning unit.

Nowadays conditioning systems of the direct or indirect free cooling type, for air-conditioning computing centers, are known and very widespread.

The term 'free cooling' means the distinctive function of a conditioning system of using external air if the conditions allow it.

Such systems use water evaporation devices as the principal system for cooling air, such air being drawn from outside, cooled and introduced directly into the computing center, a system known in the jargon as 'direct free cooling'; or evaporation machines that comprise an air/air exchanger which uses outside air to cool the warm air returning from the computing center, which is then re-introduced into the same computing center, a system known in the jargon as 'indirect free cooling'.

Should the evaporation effect alone not be sufficient to cool the air introduced into the data center, auxiliary cooling units are installed in series in the above-mentioned air-conditioning units; they are installed downstream of the evaporation exchanger, so as to ensure the temperature required for the operation of the server.

Usually the user will connect such air-conditioning units not only to a local electrical grid, but also to auxiliary current generators or to uninterruptible power supplies, in order to ensure the cooling function during a possible power outage.

In fact, if during an outage the cooling of the servers is not ensured, but those servers continue to operate because they are provided with a dedicated uninterruptible power supply, then those servers, once they reached a critical temperature, would act to safeguard their integrity by switching themselves off.

It is therefore essential to ensure a minimum useful level of cooling for the server room until the power outage ends.

Nowadays, usually, the delivery temperature in server rooms is chosen on the basis of the rated value specified for the type of server used.

Makers of servers usually design such servers to be able to operate at a temperature a few degrees higher for a brief period, in order to make operation less energy-intensive in a possible period of shutdown or malfunction of the electrical grid to which the conditioning unit is connected, when that conditioning unit is powered by an auxiliary generator or an uninterruptible power supply.

In some cases the operator of the server room has a BMS (Building Management System) through which to interface with the conditioning unit and, in an emergency, change the required parameter of temperature at delivery, increasing its value.

Such option, in addition to not being particularly widespread, in any case does not ensure that the operator can keep the maximum value of electric power absorbed under control; such option is aimed at reducing the electric power absorbed in order to make the uninterruptible power supplies, which in any case are dimensioned for maximum power, last longer.

Furthermore, usually, a conditioning unit with water evaporation devices, of both the direct and indirect free cooling type, is set up to optimize the overall cost of electricity and water, and is usually factory-set to start operation by default with water at an outside dry bulb temperature; this means that before actuating the external fans, which work in dry mode, at maximum speed, in order to provide the cooling power required, the unit starts to use water to obtain an evaporative cooling effect.

Thus, for example, in order to provide air to a server room at 24°C, it is possible that a conditioning unit will begin operation with water at a temperature above 5°C up to 19°C, all in relation to the cost of electricity and of water.

When a computing center or a server room is provided with a conditioning unit of the free cooling type with a water evaporation cooling device, one of the requirements is to identify the maximum consumption of water for 24 hours or 36 hours, choosing the worst day of the year, assuming full demand for cooling.

Based on such calculated consumption, the user of the conditioning unit installs a useful water buffer in order to ensure the cooling capacity even in the event of an outage of the water service; usually this is a tank that can hold numerous cubic meters of water which must be positioned proximate to the unit and must be kept at a temperature lower than 21°C in order to prevent the proliferation of bacteria or treated with adapted disinfectants.

Furthermore, in most free cooling conditioning units with a water evaporation cooling device, the evaporation system alone is not sufficient to ensure that the delivery temperature meets the rated requirements of the server on the hottest and most humid days; for this reason, downstream of the evaporation cooling device one or more cooling circuits are installed, with a fixed-capacity or modulating compressor, in order to further cool the air before it is introduced into the computing center or into the server room to be air-conditioned.

When the wet bulb temperature is very close to the delivery temperature required, it is much more efficient to operate the cooling circuit than it is to run the fans that move the outside air at maximum speed.

The electricity consumption of a fan can in fact be approximated to a cubic function of the air flow, so it is inefficient in these situations to move too much air in order to obtain the cooling capacity (because it is penalized by the minimal difference between the outside temperature and the desired delivery temperature).

Furthermore, differently from other cooling systems, such as those based on refrigerated water, in which there is a thermal inertia of a tank to take advantage of to maintain a cooling capacity for a certain period, in conditioning units that use air (direct or indirect free cooling) the inertia is practically nil; for this reason it is absolutely necessary to place all or part of the cooling system on an emergency electrical line.

Often, in order to reduce the cost associated with such emergency line, only the ventilating and evaporation parts are supported during an outage. However, the maximum amperage, on which the line is dimensioned, is not greatly decreased because the conditioning units are overdimensioned, both owing to the redundancy required by the computing center or server room, and also in order to obtain a better level of efficiency (when used on partial loads, this type of conditioning unit increases its efficiency considerably).
Patent document US-A-2008/288193 discloses an exemplary air conditioning unit of the free cooling type according to the preamble of claim 1.

The aim of the present invention is to provide a conditioning unit of the free cooling type that is capable of overcoming the limitations and drawbacks of conventional conditioning units.

Within this aim, an object of the invention is to provide a conditioning unit of the free cooling type that is capable of being adapted to the actual operating conditions and of operating in the most economically advantageous mode from the point of view of energy consumption.

Another object of the invention is to provide a conditioning unit that permits reduced investments, with respect to the known art, in terms of an uninterruptible power supply, or of auxiliary generators, and usually in terms of emergency electrical grid provision.

Another object of the invention is to provide a method of using such conditioning unit.

Another object of the invention is to provide a conditioning unit and a method of using it which usually permit reduced investments with respect to the known art in terms of emergency systems for outages of electric power supply.

This aim and these and other objects which will become better evident hereinafter are achieved by a conditioning unit of the free cooling type, particularly for conditioning computing centers, of the type comprising:
- a water evaporation device for cooling a conditioning air flow,
- fans for moving said conditioning air flow,
- an auxiliary electric power supply unit,
characterized in that it comprises:
- means for detecting and signaling a type of electric power supply that is active, whether from an electrical grid or from the auxiliary electric power supply unit,
- means for measuring the electric power absorbed by said conditioning unit,
- an electronic control and management unit, preset to control the fans in order to limit the speed and power absorption of each one of said fans.

Further characteristics and advantages of the invention will become better apparent from the detailed description of a preferred, but not exclusive, embodiment of the conditioning unit according to the invention, which is illustrated for the purposes of non-limiting example in the accompanying drawings wherein:
- Figure 1 is a schematic view of a conditioning unit according to the invention;
- Figure 2 is a schematic view of a detail of the conditioning unit according to the invention;
- Figure 3 is a schematic view of a method of using a conditioning unit according to the invention.

With reference to the figures, a conditioning unit of the free cooling type, particularly for conditioning computing centers, according to the invention, is generally designated with the reference numeral 10.

Such conditioning unit 10 is of the type comprising:
- a water evaporation device 11 for cooling a conditioning air flow 12, introduced into a server room or into a computing center 13,
- fans 14 for moving the conditioning air flow 12,
- an auxiliary electric power supply unit 15, for example an uninterruptible power supply.

The conditioning unit 10 according to the invention has the peculiarity of comprising:
- means 16 for detecting and signaling the type of electric power supply that is active, whether from the electrical grid 17 or from the auxiliary power supply unit 15,
- means 18 for measuring the electric power absorbed by the conditioning unit 10,
- an electronic control and management unit 19, preset to control the fans in order to limit the speed and power absorption of each one of them.

In the present embodiment, which is illustrative and non-limiting of the invention, the conditioning unit 10 is of the type with indirect free cooling, and the water evaporation device 11 for cooling a conditioning air flow 12 is constituted by:
- an air/air heat exchanger 20, inside which two air flows 21, 22, a primary air flow 21, which arrives from the server room 13 and is directed toward the server room to be air-conditioned 13, and a secondary air flow 22, or process flow, which is drawn from outside,
- first fans 14 for moving the primary air flow 21, which exiting from the exchanger 20 is constituted by the conditioning flow 12,
- second fans 23 for moving the secondary air flow 22.

The first fans 14 can suck or blow with respect to the exchanger 20.

The second fans 23 regulate the cooling power of the unit.

The air/air heat exchanger 20 comprises:
- an air cooling panel 26, with air passage holes,
- water dispensing means 27 adapted to wet the cooling panel 26 downward from above, which are constituted for example by diffuser nozzles,
- means 28 for collecting the water that descends from the cooling panel 26, which are constituted for example by a collection tank,
- a recirculation pump 29 for returning the air-cooling water from the collection means 28 up to the dispensing means 27 arranged above the cooling panel 26.

The conditioning unit 10 also comprises water accumulation means 30, for example a tank, which is adapted to collect water from a line connected to a water mains or to another, alternative water collection reservoir, for example from a rainwater collection reservoir.

The water accumulation means 30 comprise cooling means which are adapted to keep the temperature of the collected water below the temperature of bacterial proliferation.

Such means of maintaining the temperature can be constituted, for example, by an auxiliary cooling unit 32 which comprises a condensation battery 33, an expansion valve 34 and a compressor 35.

Such means of maintaining the temperature can be constituted, alternatively, by containers with phase-change materials 36, which are arranged inside the tank of the accumulation means.

The means of maintaining the temperature can comprise both the auxiliary cooling unit 32 and the containers with phase-change materials 36.

The water accumulation means 30 supply top-up water to the water evaporation cooling device 11, for example by way of a supply line 37, for introducing water into the conditioning unit 10, which connects the water accumulation means 30 to the collection means 28.

A heat exchanger 38, for example a finned pack, can be connected by plumbing on such supply line 37 and arranged downstream of the cooling panel 26, which uses the cold water arriving from the accumulation means 30 and intended for the collection means 28 in order to contribute to the cooling of the conditioning flow 21 that exits from the cooling panel 26.

The conditioning unit 10 also comprises an auxiliary cooling device 40, constituted for example by a direct expansion cooling circuit, which is installed to supplement the cooling power provided by the water evaporation device 11.

Such auxiliary cooling device 40 comprises an evaporation battery 41 arranged downstream of the water evaporation cooling device 11, and a corresponding compressor 42, condensation battery 43, and expansion valve 44.

The means 16 for detecting and signaling the type of electric power supply that is active are constituted by an Automatic Transfer Switch installed on board the machine and preset to switch the electric power supply from the fixed main grid line 17 to the emergency line, connected to the auxiliary electric power supply unit 15 automatically when the main power supply is no longer available.

Alternatively, the means for detecting and signaling the type of power can be defined by the BMS (Building Management System) that is integrated in the conditioning unit 10.

The means 18 for measuring the electric power absorbed by the conditioning unit 10 are constituted by a wattmeter for measuring absorbed current.

The electronic control and management unit 19 comprises a Modbus card for controlling fans in order to be able to limit the speed and absorbed power of each one of them.

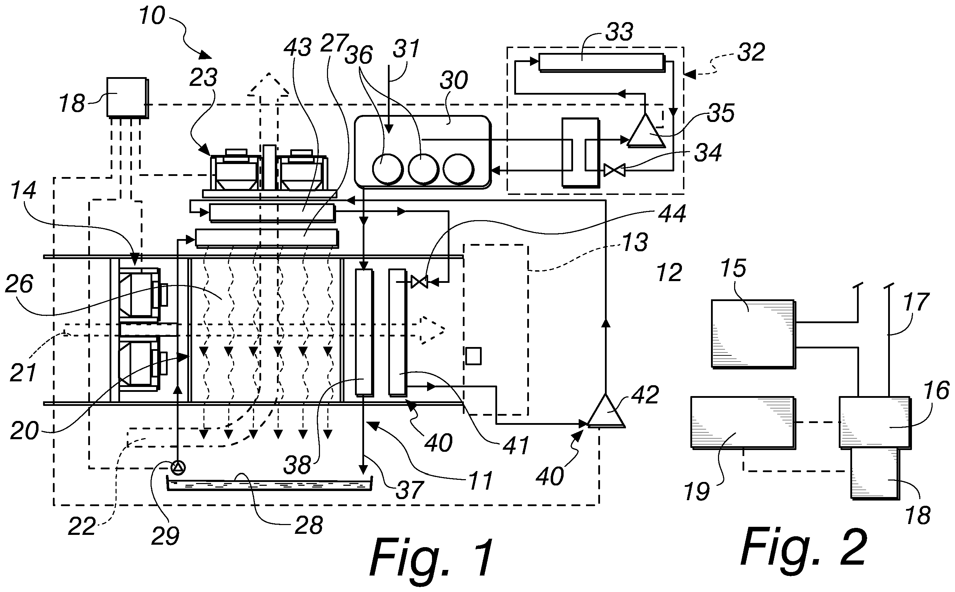

The electronic control and management unit 19, as shown schematically in Figure 2, is interconnected with the detection means 16, i.e. with the Automatic Switch, and with the means 18 for measuring the power.

Use of the conditioning unit 10 according to the invention is the following.

When starting up the conditioning unit 10, or at a later time, the user can set the maximum power that the conditioning unit can consume under electrical emergency conditions.

The emergency signal can be given by the BMS associated with the conditioning unit 10, or automatically by the Automatic Transfer Switch installed on board the machine, when it receives current from the auxiliary electric power supply unit 15.

By way of the means for measuring the electric power 18, i.e. the wattmeter, the control unit 19 if necessary limits the speed of the fans or the use of the compressor 42 of the auxiliary cooling device 40 so as to never exceed the maximum power threshold set.

Alternatively, measuring the electric power absorbed can be done by only reading the consumption of the fans.

When starting up the system, or at a later time, the user can set an optional temperature of delivery to the server room 13, to be used in emergency conditions in order to reduce consumption of electricity.

The control unit 19 uses such optional delivery temperature on the basis of reaching the maximum power threshold or not.

In the event of an emergency, the control unit 19 determines a greater use of water in order to reduce electricity consumption, and does not evaluate the use of water so as to optimize consumption based on the cost of electricity and on the cost of water.

Therefore even if it should be economically disadvantageous to resort more to the use of water, in the event of an outage or in any case a failure by the grid to supply electricity, such option is activated in order to minimize electricity consumption.

The finned pack heat exchanger 38, arranged downstream of the water evaporation cooling device 11, uses the cold water entering from the water mains or from the accumulation means 30 in order to cool the conditioning air flow 12; the electronic control unit 19 determines a consumption of water greater than that necessary for the normal operation of the water evaporation device 11, so as to increase the cooling capacity deriving from such heat exchanger 38, which usually operates with laminar flow and is instead placed in conditions of operation with turbulent water passing through it.

The conditioning unit 10 according to the invention can be either without water accumulation means 30, with a supply line 37 connected directly with a water mains 31, or with water accumulation means 30 as in Figure 1, with an auxiliary cooling circuit 32; with such auxiliary cooling circuit 32 the temperature of the water in the accumulation means 30 is lowered in advance, so that when an outage occurs, the conditioning unit 10 has, for a period linked to the size of the reserve, a source of very cold water to be used in the finned pack heat exchanger packed 38.

Furthermore, the accumulation means 30 can have, inside the accumulation tank, containers with phase-change materials (PCM); in this manner, for the same volume of the accumulation tank, water is available for more time at a temperature lower than that of the water mains.

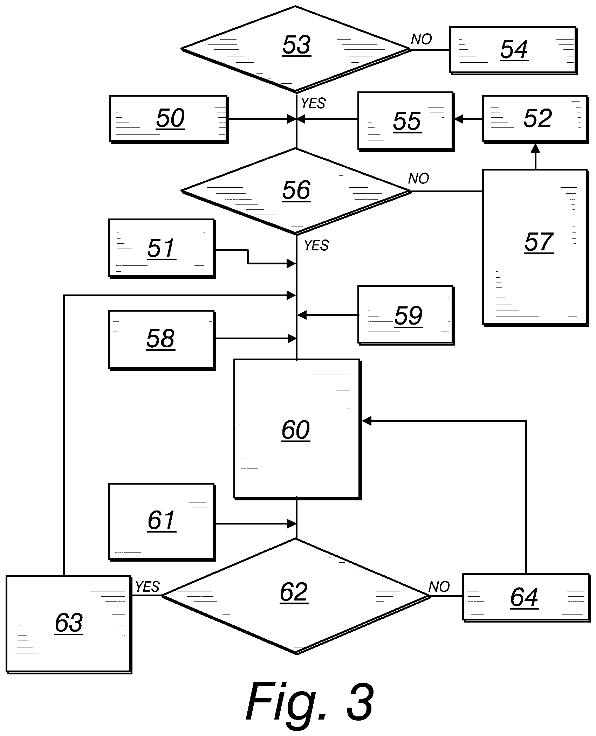

The invention also relates to a method of using a conditioning unit 10 as described above; such method is shown schematically in the block diagram in Figure 3.

Such method of use is characterized in that it comprises the following operations:
- establishing an emergency maximum power value at which the conditioning unit 10 is adapted to operate in the event of an electrical emergency, i.e., in the event of an outage of the electric power supply from the grid 17, block 50,
- establishing an emergency delivery temperature, higher than the rated delivery temperature, for the air flow entering a server room in the event of an electrical emergency, block 51,
- detecting and recording the electric power absorbed by the fans 14 and 23, block 52,
- detecting the status of the electric power supply, block 53,
- if no electrical emergency situation is detected, i.e. if the ATS or the BMS do not report the outage of the electric power supply from the grid 17, then the conditioning unit 10 remains in its normal operating state, block 54,
- if an electrical emergency situation is detected, i.e. if the ATS or the BMS report the outage of the electric power supply from the grid 17, then:
- assuming the last recorded value of electric power absorbed by the fans 14 and 23, block 55, and comparing it with the emergency maximum power value, block 56;
- if the absorbed electric power is not greater than the value of the emergency maximum power, then the conditioning unit 10 operates by maintaining the rated delivery temperature as a reference temperature for the delivery, and by operating in standard mode, block 57,
- if the absorbed electric power is greater than the value of the emergency maximum power, then the conditioning unit 10 operates, based on the reading of the outside temperature and of the outside humidity of the incoming air flow 22, block 58, and on the reading of the temperature of the water entering the water evaporation cooling device 11, or entering the heat exchanger 38, block 59, then the conditioning unit 10 operates so as to optimize consumption of water and electric power, block 60;
- detecting the temperature of delivery to the server room 13, block 61,
- comparing the temperature of delivery to the server room with the emergency delivery temperature value, block 62,
- if the demand for cooling is met, then adjusting the cooling power by acting on the speed of the second fans 23, block 63,
- if the demand for cooling is not met, then increasing the use of water entering the water evaporation cooling device in order to reduce electricity consumption, block 64.

In practice it has been found that the invention fully achieves the intended aim and objects.

In particular, with the invention a conditioning unit for server rooms of the free cooling type has been devised, which makes it possible for the user to have a lower initial cost for the auxiliary electric power supply unit, uninterruptible power supply, or generator, which can be factored to be as contained and economic as the user considers acceptable in emergency operation, thanks to the possibility of the conditioning unit, and the method of using it, to give priority to the use of cooling water in order to diminish the overall electricity consumption of that unit.

Therefore such conditioning unit makes it possible for the emergency electrical grid to be dimensioned for a lower amperage with respect to a similar conventional conditioning unit, moreover with a reduction of the machine rooms for uninterruptible power supplies or of the space occupied by generators, a reduction in the costs of cooling the rooms that contain the uninterruptible power supplies/batteries, a reduction in the costs of replacing the batteries or of maintenance on the generators, and a reduction in the current dissipated by uninterruptible power supplies, which is linked to the conversion inefficiencies thereof.

Moreover, with the invention a conditioning unit has been devised which makes it possible to cool a server room or computing center to the rated temperature if the electricity consumption does not exceed the maximum threshold.

Furthermore, with the invention a conditioning unit has been devised that does not require a BMS (usually developed by a third party firm) because the signal that the emergency electrical grid is being used is provided by the Automatic Transfer Switch which is integrated in the conditioning unit.

The invention, thus conceived, is susceptible of numerous modifications and variations, all of which are within the scope of the appended claims. Moreover, all the details may be substituted by other, technically equivalent elements.

In practice the components and the materials employed, provided they are compatible with the specific use, and the contingent dimensions and shapes, may be any according to requirements and to the state of the art.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A conditioning unit of the free cooling type (10), particularly for conditioning computing centers, of the type comprising:
- a water evaporation device (11) for cooling a conditioning air flow (12),
- fans (14) for moving said conditioning air flow,
- an auxiliary electric power supply unit (15),
- means (18) for measuring electric power absorbed by said conditioning unit, **characterized in that** it comprises:
- means (16) for detecting and signaling a type of electric power supply that is active, whether from an electrical grid or from the auxiliary electric power supply unit,
- an electronic control and management unit (19), preset to control the fans in order to limit the speed and power absorption of each one of said fans.

2. The conditioning unit according to claim 1, **characterized in that** it is of the indirect free cooling type, said water evaporation device (11) comprising:
- an air/air heat exchanger (20), inside which two air flows (21, 22), a primary air flow (21), which arrives from a server room (13) and is directed toward said server room to be air-conditioned (13), and a secondary air flow (22), or process flow, which is drawn from outside,
- first fans (14) for moving said primary air flow (21),
- second fans (23) for moving said secondary air flow (22).

3. The conditioning unit according to one or more of the preceding claims, **characterized in that** said air/air heat exchanger (20) comprises:
- an air cooling panel (26),
- water dispensing means (27) adapted to wet said cooling panel (26) downward from above,
- means (28) for collecting the water that descends from the cooling panel (26),
- a recirculation pump (29) for returning the air-cooling water from the collection means (28) up to the dispensing means (27) arranged above the cooling panel (26).

4. The conditioning unit according to one or more of the preceding claims, **characterized in that** it comprises water accumulation means (30).

5. The conditioning unit according to one or more of the preceding claims, **characterized in that** said water accumulation means (30) are adapted to supply top-up water to said water evaporation cooling device (11), by way of a supply line (37) which connects the water accumulation means (30) to the collection means (28).

6. The conditioning unit according to one or more of the preceding claims, **characterized in that** a heat exchanger (38) has a plumbing connection on said supply line (37), is arranged downstream of the cooling panel (26) and uses the cold water arriving from the accumulation means (30) and intended for the collection means (28) in order to contribute to the cooling of the conditioning flow (21) that exits from the cooling panel (26).

7. The conditioning unit according to one or more of the preceding claims, **characterized in that** it comprises an auxiliary cooling device (40), installed to supplement the cooling power provided by the water evaporation device (11).

8. The conditioning unit according to one or more of the preceding claims, **characterized in that** said auxiliary cooling device (40) comprises an evaporation battery (41) arranged downstream of the water evaporation cooling device (11) and a corresponding compressor (42), condensation battery (43), and expansion valve (44).

9. The conditioning unit according to one or more of the preceding claims, **characterized in that** said means (16) for detecting and signaling the type of electric power supply that is active are constituted by an Automatic Transfer Switch installed on board the machine and preset to switch the electric power supply from a main grid line (17) to an emergency line, connected to the auxiliary electric power supply unit (15) automatically when the main power supply is no longer available.

10. The conditioning unit according to one or more of the preceding claims, **characterized in that** said means (18) for measuring the electric power absorbed by said conditioning unit (10) are constituted by a wattmeter for measuring absorbed current.

11. The conditioning unit according to one or more of the preceding claims, **characterized in that** said electronic control and management unit (19) comprises a Modbus card for controlling fans in order to be able to limit the speed and absorbed power of each one.

12. A method of using a conditioning unit (10) according to one or more of the preceding claims, **characterized in that** it comprises the following operations:
- establishing an emergency maximum power value at which said conditioning unit (10) is adapted to operate in the event of an electrical emergency, i.e., in the event of an outage of the electric power supply from the grid (17),
- establishing an emergency delivery temperature for an air flow entering a server room (13) in the event of an electrical emergency,
- detecting and recording electric power absorbed by the fans (14, 23),
- detecting a status of the electric power supply,
- if no electrical emergency situation is detected, then the conditioning unit (10) remains in its normal operating state,
- if an electrical emergency situation is detected, then:
- assuming a last recorded value of electric power absorbed by the fans (14, 23) and comparing it with said emergency maximum power value;
- if the absorbed electric power is not greater than the value of the emergency maximum power, then the conditioning unit (10) operates by maintaining the rated delivery temperature as a reference temperature for the delivery, and by operating in standard mode,
- if the absorbed electric power is greater than the value of the emergency maximum power, then the conditioning unit (10) operates, based on the reading of the outside temperature and of the outside humidity of the incoming air flow (22), and on the reading of the temperature of the water entering the water evaporation cooling device (11), or entering the heat exchanger (38), so as to optimize consumption of water and electric power in order to reach the emergency delivery temperature;
- detecting a temperature of delivery to the server room (13),
- comparing the temperature of delivery to the server room with the emergency delivery temperature value,
- if a demand for cooling is met, then adjusting the cooling power by acting on the speed of the second fans (23),
- if the demand for cooling is not met, then increasing the use of water entering the water evaporation cooling device (11) in order to reduce electricity consumption.

## Patentansprüche

1. Eine Klimaanlage mit freier Kühlung (10), insbesondere zur Klimatisierung von Rechenzentren, von dem Typ, der Folgendes umfasst:
- eine Wasserverdunstungsvorrichtung (11) zum Kühlen eines klimatisierenden Luftstroms (12),
- Ventilatoren (14) zum Bewegen des klimatisierenden Luftstroms,
- eine Hilfsstromversorgungseinheit (15),
- Mittel (18) zur Messung der elektrischen Energie, die von der Klimaanlage verbraucht wird,
**dadurch gekennzeichnet, dass** sie Folgendes umfasst:
- Mittel (16) zur Erfassung und Meldung einer Art von Stromversorgung, die aktiv ist, ob von einem Stromnetz oder von der Hilfsstromversorgungseinheit,
- eine elektronische Steuer- und Verwaltungseinheit (19), die voreingestellt ist, um die Ventilatoren zu steuern, um die Geschwindigkeit und den Energieverbrauch jedes der Ventilatoren zu begrenzen.

2. Die Klimaanlage gemäß Anspruch 1, **dadurch gekennzeichnet, dass** sie vom Typ mit indirekter freier Kühlung ist, wobei die Wasserverdunstungsvorrichtung (11) Folgendes umfasst:
- einen Luft/Luft-Wärmetauscher (20), in dem zwei Luftströme (21, 22) strömen, und zwar ein primärer Luftstrom (21), der von einem Serverraum (13) kommt und zu dem zu klimatisierenden Serverraum (13) hin gelenkt wird, und ein sekundärer Luftstrom (22), oder Prozessstrom, der von außen hereingezogen wird,
- erste Ventilatoren (14) zum Bewegen des primären Luftstroms (21),
- zweite Ventilatoren (23) zum Bewegen des sekundären Luftstroms (22).

3. Die Klimaanlage gemäß einem oder mehreren der obigen Ansprüche, **dadurch gekennzeichnet, dass** der Luft/Luft-Wärmetauscher (20) Folgendes umfasst:
- eine Luftkühlungsplatte (26),
- Wasserabgabemittel (27), das ausgebildet ist, um die Kühlplatteh (26) von oben nach unten zu benetzen,
- Mittel (28) zum Sammeln des Wassers, das von der Kühlplatte (26) herabläuft,
- eine Rückförderpumpe (29) zum Zurückpumpen des Luftkühlwassers von den Sammelmitteln (28) hoch zu den Abgabemitteln (27), die oberhalb der Kühlplatte (26) angeordnet sind.

4. Die Klimaanlage gemäß einem oder mehreren der obigen Ansprüche, **dadurch gekennzeichnet, dass** sie Wasseransammlungsmittel (30) umfasst.

5. Die Klimaanlage gemäß einem oder mehreren der obigen Ansprüche, **dadurch gekennzeichnet, dass** die Wasseransammlungsmittel (30) ausgebildet sind, um Nachfüllwasser der Wasserverdunstungs-Kühlvorrichtung (11) über eine Versorgungsleitung (37) zuzuführen, welche die Wasseransammlungsmittel (30) mit den Sammelmitteln (28) verbindet.

6. Die Klimaanlage gemäß einem oder mehreren der obigen Ansprüche, **dadurch gekennzeichnet, dass** ein Wärmetauscher (38) eine Rohrleitungsverbindung an der Versorgungsleitung (37) hat, stromabwärts vom Kühlblech (26) angeordnet ist und das kalte Wasser verwendet, das von den Ansammlungsmitteln (30) kommt und für die Sammelmittel (28) bestimmt ist, um zum Kühlen der Klimatisierungsströmung (21) beizutragen, die aus dem Kühlblech (26) austritt.

7. Die Klimaanlage gemäß einem oder mehreren der obigen Ansprüche, **dadurch gekennzeichnet, dass** sie eine Hilfskühlvorrichtung (40) umfasst, die angebracht ist, um die von der Wasserverdunstungsvorrichtung (11) bereitgestellte Kühlleistung zu ergänzen.

8. Die Klimaanlage gemäß einem oder mehreren der obigen Ansprüche, **dadurch gekennzeichnet, dass** die zusätzliche Kühlvorrichtung (40) Folgendes umfasst: eine Verdunstungsbatterie (41), die stromabwärts von der Wasserverdunstungs-Kühlvorrichtung (11) angeordnet ist, und einen entsprechenden Kompressor (42), eine Kondensationsbatterie (43) und eine Expansionsventil (44).

9. Die Klimaanlage gemäß einem oder mehreren der obigen Ansprüche, **dadurch gekennzeichnet, dass** die Mittel (16) zur Erfassung und Meldung der Art von Stromversorgung, die aktiv ist, aus einem automatischen Transferschalter bestehen, der in der Maschine installiert ist und voreingestellt ist, um die Stromversorgung von einer Stromnetzleitung (17) automatisch zu einer Notleitung zu schalten, die mit der Hilfsstromversorgungseinheit (15) verbunden ist, wenn die Hauptstromversorgung nicht mehr verfügbar ist.

10. Die Klimaanlage gemäß einem oder mehreren der obigen Ansprüche, **dadurch gekennzeichnet, dass** die Mittel (18) zur Messung dee elektrischen Energie, die von der Klimaanlage (10) verbraucht wird, aus einem Wattmeter zur Messung des aufgenommenen Stroms bestehen.

11. Die Klimaanlage gemäß einem oder mehreren der obigen Ansprüche, **dadurch gekennzeichnet, dass** die elektronische Steuerungs- und Verwaltungseinheit (19) eine Modbus-Karte zum Steuern der Ventilatoren umfasst, um die Geschwindigkeit und die verbrauchte Energie jedes Ventilators begrenzen zu können.

12. Ein Verfahren zur Verwendung einer Klimaanlage (10) gemäß einem oder mehreren der obigen Ansprüche, **dadurch gekennzeichnet, dass** es folgende Arbeitsschritte umfasst:
- Festlegen eines maximalen Not-Energiewerts, bei dem die Klimaanlage (10) ausgebildet ist, im Fall eines elektrischen Notfalls zu arbeiten, nämlich für den Fall eines Stromausfalls vom Netz (17),
- Festlegen einer Not-Abgabetemperatur für einen Luftstrom, der in einen Serverraum (13) eindringt, für den Fall eines elektrischen Notfalls,
- Erfassen und Speichern der elektrischen Energie, die durch die Ventilatoren (14, 23) aufgenommen wird,
- Erfassen eines Status der Stromversorgung,
- wenn keine elektrische Notfallsituation erfasst wird, dann bleibt die Klimaanlage (10) in ihrem normalen Arbeitszustand,
- wenn eine elektrische Notfallsituation erfasst wird, dann:
- Annehmen eines letzten gespeicherten Werts der elektrischen Energie, die von den Ventilatoren (14, 23) aufgenommen wurde, und Vergleichen desselben mit dem maximalen Not-Energiewert;
- wenn die aufgenommene elektrische Energie nicht höher ist als der maximale Not-Energiewert, dann arbeitet die Klimaanlage (10), indem sie die Nenn-Abgabetemperatur als Referenztemperatur für die Abgabe beibehält und im Standardmodus arbeitet;
- wenn die aufgenommenen elektrische Energie höher ist als der maximale Not-Energiewert, dann arbeitet die Klimaanlage (10) basierend auf der Ablesung der Außentemperatur und der Außen-Feuchtigkeit des einströmenden Luftstroms (22) und auf der Ablesung der Temperatur des Wassers, das in die Wasserverdunstungs-Kühlvorrichtung (11) oder in den Wärmetauscher (38) eintritt, um so den Verbrauch von Wasser und elektrischer Energie zu optimieren, um die Not-Abgabetemperatur zu erreichen;
- Erfassen einer Temperatur der Abgabe an den Serverraum (13),
- Vergleichen der Temperatur der Abgabe an den Serverraum mit dem Not-Abgabetemperaturwert,
- wenn dem Kühlungsbedarf entsprochen ist, Anpassen der Kühlleistung durch Einwirken auf die Geschwindigkeit der zweiten Ventilatoren (23),
- wenn dem Kühlungsbedarf nicht entsprochen ist, Erhöhen des Verbrauchs von Wasser, das in die Wasserverdunstungs-Kühlvorrichtung (11) eintritt, um den Verbrauch an Elektrizität zu reduzieren.

## Revendications

1. Unité de conditionnement du type à refroidissement libre (10), en particulier pour conditionner des centres informatiques, comportant :
- un dispositif d'évaporation d'eau (11) pour refroidir un flux d'air conditionné,
- des ventilateurs (14) pour créer ledit flux d'air de conditionnement,
- une unité auxiliaire d'alimentation électrique (15),
- des moyens (18) pour mesurer l'énergie électrique absorbée par ladite unité de conditionnement,
**caractérisée en ce qu'**elle comporte :
- des moyens (16) pour détecter et signaler un type d'alimentation électrique qui est active, s'il provient d'un réseau électrique ou de l'unité auxiliaire d'alimentation électrique,
- une unité de commande et de gestion électronique (19), préréglée pour commander les ventilateurs afin de limiter la vitesse et l'absorption d'énergie de chacun desdits ventilateurs.

2. Unité de conditionnement selon la revendication 1, **caractérisée en ce qu'**elle est du type à refroidissement libre indirect, ledit dispositif d'évaporation d'eau (11) comportant :
- un échangeur de chaleur air/air (20), à l'intérieur duquel deux flux d'air (21, 22), un flux d'air primaire (21), qui arrive d'une salle de serveurs (13) et est dirigé vers ladite salle de serveurs à climatiser (13), et un flux d'air secondaire (22), ou flux de procédé, qui est aspiré depuis l'extérieur,
- des premiers ventilateurs (14) pour créer ledit flux d'air primaire (21),
- des seconds ventilateurs (23) pour créer ledit flux d'air secondaire (22).

3. Unité de conditionnement selon une ou plusieurs des revendications précédentes, **caractérisée en ce que** ledit échangeur de chaleur air/air (20) comporte :
- un panneau de refroidissement d'air (26),
- des moyens de distribution d'eau (27) adaptés pour humidifier ledit panneau de refroidissement (26) vers le bas à partir du dessus,
- des moyens (28) pour recueillir l'eau qui descend à partir du panneau de refroidissement (26),
- une pompe de recirculation (29) pour renvoyer l'eau de refroidissement d'air à partir des moyens de collecte (28) jusqu'aux moyens de distribution (27) agencés au-dessus du panneau de refroidissement (26).

4. Unité de conditionnement selon une ou plusieurs des revendications précédentes, **caractérisée en ce qu'**elle comporte des moyens d'accumulation d'eau (30).

5. Unité de conditionnement selon une ou plusieurs des revendications précédentes, **caractérisée en ce que** lesdits moyens d'accumulation d'eau (30) sont adaptés pour fournir de l'eau d'appoint audit dispositif de refroidissement par évaporation d'eau (11), au moyen d'une ligne d'alimentation (37) qui relie les moyens d'accumulation d'eau (30) aux moyens de collecte (28).

6. Unité de conditionnement selon une ou plusieurs des revendications précédentes, **caractérisée en ce qu'**un échangeur de chaleur (38) a un raccord de plomberie sur ladite ligne d'alimentation (37), est agencé en aval du panneau de refroidissement (26) et utilise l'eau froide arrivant des moyens d'accumulation (30) et destinée aux moyens de collecte (28) afin de contribuer au refroidissement du flux de conditionnement (21) qui sort du panneau de refroidissement (26).

7. Unité de conditionnement selon une ou plusieurs des revendications précédentes, **caractérisée en ce qu'**elle comporte un dispositif de refroidissement auxiliaire (40), installé de manière à compléter la puissance de refroidissement fournie par le dispositif d'évaporation d'eau (11).

8. Unité de conditionnement selon une ou plusieurs des revendications précédentes, **caractérisée en ce que** ledit dispositif de refroidissement auxiliaire (40) comporte une batterie d'évaporation (41) agencée en aval du dispositif de refroidissement par évaporation d'eau (11) et un compresseur (42) correspondant, une batterie de condensation (43) et une soupape de détente (44).

9. Unité de conditionnement selon une ou plusieurs des revendications précédentes, **caractérisée en ce que** lesdits moyens (16) pour détecter et signaler le type de l'alimentation électrique qui est active sont constitués d'un commutateur de transfert automatique installé à bord de la machine et préréglé pour commuter automatiquement l'alimentation électrique d'une ligne de réseau principale (17) à une ligne d'urgence, raccordée à l'unité auxiliaire d'alimentation électrique (15) lorsque l'alimentation principale n'est plus disponible.

10. Unité de conditionnement selon une ou plusieurs des revendications précédentes, **caractérisée en ce que** lesdits moyens (18) pour mesurer l'énergie électrique absorbée par ladite unité de conditionnement (10) sont constitués d'un wattmètre pour mesurer le courant absorbé.

11. Unité de conditionnement selon une ou plusieurs des revendications précédentes, **caractérisée en ce que** ladite unité de commande et de gestion électronique (19) comporte une carte Modbus pour commander des ventilateurs afin de pouvoir limiter la vitesse et l'énergie absorbée par chacun.

12. Procédé d'utilisation d'une unité de conditionnement (10) selon une ou plusieurs des revendications précédentes, **caractérisé en ce qu'**il comporte les opérations suivantes :
- établir une valeur d'énergie maximale d'urgence à laquelle ladite unité de conditionnement (10) est apte à fonctionner dans l'éventualité d'une urgence électrique, c'est-à-dire dans l'éventualité d'une coupure de l'alimentation électrique à partir du réseau (17),
- établir une température de distribution d'urgence pour un flux d'air entrant dans une salle de serveurs (13) dans l'éventualité d'une urgence électrique,
- détecter et enregistrer une puissance électrique absorbée par les ventilateurs (14, 23),
- détecter un état de l'alimentation électrique,
- si aucune situation d'urgence électrique n'est détectée, alors l'unité de conditionnement (10) reste dans son état de fonctionnement normal,
- si une situation d'urgence électrique est détectée, alors :
- prendre une dernière valeur enregistrée de la puissance électrique absorbée par les ventilateurs (14, 23) et la comparer à ladite valeur d'énergie maximale d'urgence,
- si la puissance électrique absorbée n'est pas supérieure à la valeur de l'énergie maximale d'urgence, alors l'unité de conditionnement (10) fonctionne en maintenant la température de distribution nominale comme une température de référence pour la distribution, et en fonctionnant en mode standard,
- si la puissance électrique absorbée est supérieure à la valeur de l'énergie maximale d'urgence, alors l'unité de conditionnement (10) fonctionne, sur la base de la lecture de la température extérieure et de l'humidité extérieure du flux d'air entrant (22), et de la lecture de la température de l'eau entrant dans le dispositif de refroidissement par évaporation d'eau (11), ou entrant dans l'échangeur de chaleur (38), de manière à optimiser la consommation d'eau et d'énergie électrique afin d'atteindre la température de distribution d'urgence,
- détecter une température de distribution à la salle de serveurs (13),
- comparer la température de distribution à la salle de serveurs avec la valeur de température de distribution d'urgence,
- si une demande de refroidissement est satisfaite, alors régler la puissance de refroidissement en agissant sur la vitesse des seconds ventilateurs (23),
- si la demande de refroidissement n'est pas satisfaite, alors augmenter l'utilisation de l'eau entrant dans le dispositif de refroidissement par évaporation d'eau (11) afin de réduire la consommation d'électricité.
